# EUROPEAN PATENT APPLICATION

(11) **EP 2 716 442 A1**
(43) Date of publication of application: **09.04.2014**
(21) Application number: 12792061.9
(22) Date of filing: 30.05.2012
(51) Int. Cl.: B32B 7/02, B32B 9/00, C03C 27/06

(54) **LOW EMISSIVITY LAMINATE AND MULTI-LAYER GLASS**

(30) Priority: 30.05.2011 JP 2011119910
(71) Applicant: Asahi Glass Company, Limited, Chiyoda-ku Tokyo 100-8405 (JP)
(72) Inventor: YAOITA, Kazuya, Tokyo 100-8405 (JP)
(74) Representative: Müller-Boré & Partner Patentanwälte PartG mbB
(86) International application number: PCT/JP2012/063979
(87) International publication number: WO 2012/165501

(57) **Abstract**

To provide a low emissivity coating stack having a low emissivity for heat rays and having high visible light transmittance and near infrared transmittance.

A low emissivity coating stack 1 comprising a transparent substrate 2, and a thin film laminate portion 3 having at least a first titanium oxide-containing layer 31 containing an oxide of titanium, a low emissivity metal layer 33 containing silver as the main component and a second titanium oxide-containing layer 34 containing an oxide of titanium formed in this order on the transparent substrate 2, which has a surface resistivity of at most 3.3 Ω/□ and has a solar heat gain coefficient of at least 0.60 when formed into double glazing glass.

## Description

### TECHNICAL FIELD

The present invention relates to a low emissivity coating stack and double glazing glass. Particularly, it relates to a low emissivity coating stack suitably used for double glazing glass, and double glazing glass using the low emissivity coating stack.

### BACKGROUND ART

A low emissivity coating stack has been widely used for window glass for e.g. buildings and automobiles so as to suppress radiation of heat rays thereby to reduce the cooling and heating load. Accordingly, a low emissivity coating stack is required to have a low emissivity for heat rays so as not to let heat inside of the room escape. Accordingly, a low emissivity coating stack usually has a structure containing a metal layer having low emission property. For example, a laminate having a first transparent oxide layer, a low emissivity metal layer and a second transparent oxide layer laminated in this order on a transparent substrate such as a glass substrate, and a laminate further having a low emissivity metal layer and a transparent oxide layer repeatedly laminated, have been known (for example, Patent Documents 1 and 2). On the other hand, it is also required to take in visible light from the viewpoint of brightness inside of the room and to take in light in a near infrared region with a view to taking in solar heat. Accordingly, a low emissivity coating stack is required to satisfy both of a low emissivity for heat rays and high visible light transmittance and near infrared transmittance, with a view to obtaining more excellent properties.

### PRIOR ART DOCUMENTS

### PATENT DOCUMENTS

Patent Document 1: JP-A-62-41740
Patent Document 2: JP-A-5-229052

### DISCLOSURE OF INVENTION

### TECHNICAL PROBLEM

Usually, the surface resistivity of a low emissivity coating stack can be lowered by making a low emissivity metal layer thick, whereby the emissivity for heat rays can be lowered. Here, the emissivity for heat rays and the surface resistivity of the low emissivity coating stack are in substantially one-on-one relation, and the emissivity for heat rays can be lowered by lowering the surface resistivity of the low emissivity coating stack. However, in a case where the low emissivity metal layer is made thick, the visible light transmittance and the near infrared transmittance tend to be low, and the solar heat gain coefficient when such a low emissivity coating stack is formed into double glazing glass tends to be low. On the contrary, by making the low emissivity metal layer thin, the visible light transmittance and the near infrared transmittance can be increased, and the solar heat gain coefficient when such a laminate is formed into double glazing glass can be made high. However, if the low emissivity metal layer is made thin, the surface resistivity of the low emissivity coating stack tends to be high, and the emissivity for heat rays tends to be high. In such a manner, the low emissivity coating stack has such a problem that the visible light transmittance and the near infrared transmittance tend to be low when the emissivity for heat rays is low, and on the other hand, the emissivity for heat rays tends to be high if the visible light transmittance or the near infrared transmittance is increased. A technique which satisfies these conflicting requirements to obtain a low emissivity coating stack having excellent properties has not been present.

Under these circumstances, the present invention has been made to solve the above problem, and its object is to provide a low emissivity coating stack having a sufficiently low emissivity for heat rays and having sufficiently high visible light transmittance and near infrared transmittance, and having excellent properties as compared with a conventional product. Further, another object of the present invention is to provide double glazing glass having excellent properties as compared with a conventional product by using such a low emissivity coating stack.

### SOLUTION TO PROBLEM

The low emissivity coating stack of the present invention has a surface resistivity of at most 3.3 Ω/□ and has a solar heat gain coefficient of at least 0.60 when formed into double glazing glass.

The low emissivity coating stack of the present invention comprises a transparent substrate, and a thin film laminate portion having at least a first titanium oxide-containing layer containing an oxide of titanium, a low emissivity metal layer containing silver as the main component, and a second titanium oxide-containing layer containing an oxide of titanium formed in this order on the transparent substrate.

The double glazing glass of the present invention is double glazing glass comprising a low emissivity coating stack and a transparent counter substrate disposed to face the low emissivity coating stack, wherein the low emissivity coating stack is the low emissivity coating stack of the present invention.

### ADVANTAGEOUS EFFECTS OF INVENTION

According to the present invention, it is possible to provide a low emissivity coating stack having a surface resistivity of at most 3.3 Ω/□ and having a solar heat gain coefficient of at least 0.60 when formed into double glazing glass, which has excellent properties as compared with a conventional product.

Further, according to the present invention, it is possible to provide double glazing glass having excellent properties as compared with a conventional product, by using the low emissivity coating stack of the present invention i.e. a low emissivity coating stack having a surface resistivity of at most 3.3 Ω/□ and having a solar heat gain coefficient of at least 0.60 when formed into double glazing glass.

### BRIEF DESCRIPTION OF DRAWINGS

Fig. 1 is a cross sectional view illustrating one example of a low emissivity coating stack according to a first embodiment.
Fig. 2 is a cross sectional view illustrating one example of a low emissivity coating stack according to a second embodiment.
Fig. 3 is a cross sectional view schematically illustrating one example of double glazing glass of the present invention.
Fig. 4 is a graph illustrating the relation between a target material and the surface resistivity (Rs) of a low emissivity coating stack.

### DESCRIPTION OF EMBODIMENTS

Now, embodiments of a low emissivity coating stack of the present invention will be described.

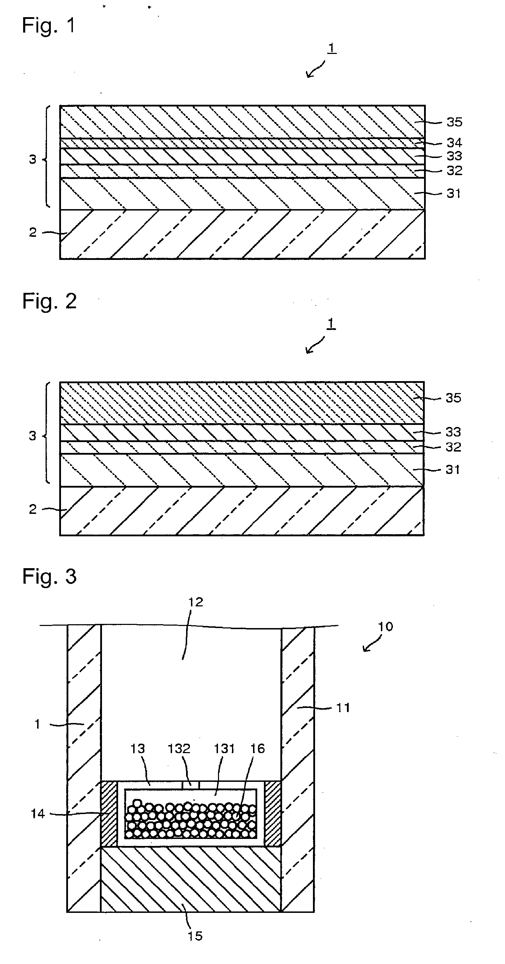

Fig. 1 is a cross sectional view schematically illustrating one example of a low emissivity coating stack according to a first embodiment. Fig. 1 shows a state of the respective layers at the film forming stage.

A low emissivity coating stack 1 comprises a transparent substrate 2 and a thin film laminate portion 3 formed on the transparent substrate 2. The thin film laminate portion 3 is formed, for example, by a first transparent oxide layer 31, a base oxide layer 32, a low emissivity metal layer 33, an antioxidant barrier layer 34 and a second transparent oxide layer 35 in this order from the transparent substrate 2 side. In the low emissivity coating stack 1 of the present invention, the first transparent oxide layer 31 corresponds to the first titanium oxide-containing layer of the present invention, and the antioxidant barrier layer 34 corresponds to the second titanium oxide-containing layer of the present invention.

The transparent substrate 2 is not particularly limited so long as it is transparent, and it may, for example, be float plate glass of e.g. soda lime glass commonly used as e.g. window glass for buildings, or inorganic transparent plate glass of e.g. soda lime glass produced by a roll out method. As such plate glass, either of colorless glass such as clear glass (transparent glass) or high-transparent glass and glass colored green or the like such as heat ray-absorbing glass may be used, and the shape, etc. of glass are not particularly limited. However, considering the visible light transmittance and the like, preferred is colorless glass such as clear glass or high-transparent glass. Particularly, to achieve a solar heat gain coefficient of at least 0.60, preferred is colorless glass such as clear glass or high-transparent glass, having a high visible light transmittance particularly solar energy transmittance.

Further, not only flat glass or curved glass but also tempered glass such as air-quenched tempered glass or chemically tempered glass and in addition, wired glass may be used. Further, various glass substrates made of e.g. borosilicate glass, low expansion glass, zero-expansion glass, low expansion crystallized glass or zero-expansion crystallized glass may be used. Further, a substrate other than the glass substrate may, for example, be an amorphous resin substrate of e.g. a polyethylene terephthalate resin, a polycarbonate resin, a polyvinyl chloride resin or a polyethylene resin. The thickness of the transparent substrate 2 is not particularly limited, but is usually preferably from 1 to 10 mm.

The first transparent oxide layer 31 (i.e. the first titanium oxide-containing layer) contains an oxide of titanium. By containing an oxide of titanium, high visible light transmittance and near infrared transmittance can be achieved. The first transparent oxide layer 31 may be formed by an oxide which satisfies a stoichiometric composition relative to the stoichiometric composition, and it preferably has a high oxidation degree as compared with the antioxidant barrier layer 34 formed by an oxide of titanium similarly, and it is particularly preferably formed by an oxide which satisfies a stoichiometric composition.

The first transparent oxide layer 31 preferably contains an oxide of titanium as the main component. "Containing an oxide of titanium as the main component" means that titanium is contained in a proportion of at least 50 atomic % in the total amount (100 atomic %) of titanium and an oxide constituting element (excluding oxygen) other than titanium. By containing an oxide of titanium as the main component, higher visible light transmittance and near infrared transmittance can be achieved.

The first transparent oxide layer 31 may contain an oxide constituting element other than titanium. The oxide constituting element other than titanium may, for example, be niobium, tantalum, zirconium, silicon, tungsten or molybdenum, and one or more of them may be contained.

Titanium, niobium, tantalum, zirconium, silicon, tungsten and molybdenum are contained in the first transparent oxide layer 31, for example, as titanium oxide (TiO₂), niobium oxide (Nb₂O₅), tantalum oxide (Ta₂O₅), zirconium oxide (ZrO₂), silicon oxide (SiO₂), tangusten oxide (WO₃) and molybdenum oxide (MoO₃), respectively, or a composite oxide thereof.

In a case where the first transparent oxide layer 31 contains an oxide constituting element other than titanium, with a view to making the visible light transmittance and the near infrared transmittance high, the proportion of the oxide constituting element other than titanium is preferably at most 30 atomic %, more preferably at most 20 atomic %, further preferably at most 10 atomic % in the total amount (100 atomic %) of titanium and the oxide constituting element (excluding oxygen) other than titanium. The first transparent·oxide·layer 31 is preferably formed particularly only by an oxide of titanium, with a view to making the visible light transmittance and the near infrared transmittance high, particularly preferably formed only by titanium oxide (TiO₂) having a stoichiometric composition.

The thickness of the first transparent oxide layer 31 is not particularly limited and is preferably from 10 to 30 nm. When the thickness of the first transparent oxide layer 31 is at least 10 nm, the visible light transmittance and the near infrared transmittance can be made high. A thickness of the first transparent oxide layer 31 of 30 nm is sufficient to make the visible light transmittance and the near infrared transmittance high, and when it is at most 30 nm, the film forming time can be shortened, thus leading to favorable productivity.

In this specification, "to" used to show the range of the numerical values is used to include the numerical values before and after it as the lower limit value and the upper limit value, and unless otherwise specified, the same applies hereinafter.

The base oxide layer 32 constitutes a base layer on which the low emissivity metal layer 33 is to be formed and contains, for example, an oxide of zinc as the main component. Here, "containing an oxide of zinc as the main component" means that zinc is contained in a proportion of at least 50 mass% in the total amount (100 mass%) of zinc and an oxide constituting element (excluding oxygen) other than zinc. By containing an oxide of zinc as the main component, the visible light transmittance and the near infrared transmittance can be made higher.

By containing an oxide of zinc, due to its crystallization or the like, the low emissivity metal layer 33 to be formed on the base oxide layer 32 can be made homogenous and dense. The base oxide layer 32 may contain an oxide constituting element other than zinc. The oxide constituting element other than zinc may, for example, be tin, aluminum, chromium, titanium, silicon, boron, magnesium or gallium, and one or more of them may be contained. By the base oxide layer 32 containing an oxide constituting element other than zinc, the adhesion to the first transparent oxide layer 31 will be improved, and the visible light transmittance and the near infrared transmittance can be improved.

Zinc, tin, aluminum, chromium, titanium, silicon, boron, magnesium and gallium are contained in the base oxide layer 32, for example, as zinc oxide (ZnO), tin oxide (SnO₂), aluminum oxide (Al₂O₃), chromium oxide (Cr₂O₃), titanium oxide (TiO₂), silicon oxide (SiO₂), boron oxide (B₂O₃), magnesium oxide (MgO) and gallium oxide (Ga₂O₃), respectively, or a composite oxide thereof. The oxide constituting element other than zinc is more preferably aluminum or tin, which is inexpensive. Aluminum is particularly preferred since it is an inexpensive material and it can make the film forming rate high. Tin is also preferred since it is a relatively inexpensive material.

In a case where the base oxide layer 32 contains an oxide constituting element other than zinc, the proportion of the oxide constituting element other than zinc is preferably from 1 to 50 mass% in the total amount (100 mass%) of zinc and the oxide constituting element (excluding oxygen) other than zinc. The proportion of the oxide constituting element other than zinc is at least 1 mass%, whereby the visible light transmittance and the near infrared transmittance can effectively be improved. Further, when the proportion of the oxide constituting element other than zinc is at most 50 mass%, the stability of the low emissivity metal layer 33 formed on the base oxide layer 32 can be secured. For example, in a case where the base oxide layer 32 contains aluminum, the proportion of aluminum is preferably from 1 to 10 mass%, more preferably from 1 to 5 mass% in the total amount (100 mass%) of zinc and aluminum.

The thickness of the base oxide layer 32 is preferably from 3 to 15 nm. When the thickness of the base oxide layer 32 is at least 3 nm, crystallization of the base oxide layer 32 can be promoted, and the low emissive metal layer 33 to be formed on the base oxide layer 32 can be made homogenous and dense. A thickness of the base oxide layer 32 of 15 nm is sufficient for promotion of crystallization, and when the thickness is at most 15 nm, it is possible to suppress a decrease of properties of the low emissivity metal layer 33 due to coarse surface of the base oxide layer 32. The thickness of the base oxide layer 32 is more preferably from 5 to 11 nm with a view to making the low emissivity metal layer 33 be homogenous and dense and have excellent properties.

The low emissivity metal layer 33 contains silver as the main component, and specifically contains silver in a proportion of at least 90 mass%. The low emissivity metal layer 33 may contain, in addition to silver, one or more of additional elements selected from the group consisting of palladium, gold, copper and platinum. By containing additional elements, the visible light transmittance and the near infrared transmittance can be improved and in addition, the emissivity for heat rays having a wavelength longer than the visible light or near infrared light can be lowered, and stability of silver can also be increased. However, from the viewpoint of productivity, it is preferred to use only silver.

In a case where the low emissivity metal layer 33 contains additional elements, the total amount of the additional elements is preferably from 0.1 to 10 mass% in the entire low emissivity metal layer 33. When the content of the additional elements is at least 0.1 mass%, the above effects are likely to be obtained. Further, when the content of the additional elements is at most 10 mass%, a decrease of the film forming rate, the visible light transmittance and the near infrared transmittance, an increase in the emissivity for heat rays, etc. can be suppressed. In a case where additional elements are contained, the total content is more preferably from 0.1 to 5.0 mass%, further preferably from 0.1 to 2.0 mass%.

The thickness of the low emissivity metal layer 33 is preferably from 8 to 17 nm. When the thickness of the low emissivity metal layer 33 is at least 8 nm, the surface resistivity of the low emissivity coating stack 1 can effectively be reduced, and the emissivity for heat rays can be lowered. Further, when the thickness of the low emissivity metal layer 33 is at most 17 nm, the visible light transmittance and the near infrared transmittance can be secured. The thickness of the low emissivity metal layer 33 is more preferably from 10 to 15 nm, further preferably from 11 to 14 nm with a view to securing the visible light transmittance and the near infrared transmittance while lowering the surface resistivity of the low emissivity coating stack 1.

The antioxidant barrier layer 34 (i.e. the second titanium oxide-containing layer in Fig. 1) is provided so as to suppress oxidation of the low emissivity metal layer 33 at the time of forming the second transparent oxide layer 35. The antioxidant barrier layer 34 contains an oxide of titanium and is formed by an oxide deficient in oxygen relative to the stoichiometric composition. That is, the second titanium oxide-containing layer contains TiOₓ, and x is preferably within a range of 1 <x<2, more preferably 1.5<x<2.0. By the antioxidant barrier layer 34 being formed by an oxide deficient in oxygen relative to the stoichiometric composition, oxidation of the low emissivity metal layer 33 at the time of forming the second transparent oxide layer 35 can be suppressed. The antioxidant barrier layer 34 preferably contains an oxide of titanium as the main component: "Containing an oxide of titanium as the main component" means that titanium is contained in a proportion of at least 50 atomic % in the total amount (100 atomic %) of titanium and an oxide constituting element (excluding oxygen) other than titanium.

The antioxidant barrier layer 34 may contain an oxide constituting element other than titanium. The oxide constituting element other than titanium may, for example, be niobium, tantalum, zirconium, silicon, tungsten or molybdenum, and one or more of them may be contained.

Titanium, niobium, tantalum, tungsten and molybdenum are contained in the antioxidant barrier layer 34, for example, as TiOₓ (1 <x<2), Nb₂Oₓ (4<x<5), Ta₂Oₓ (4<x<5), ZrOₓ (1<x<2), SiOₓ (1<x<2), WOₓ (2<x<3) and MoOₓ (2<x<3), respectively, or a composite oxide thereof.

In a case where the antioxidant barrier layer 34 contains an oxide constituting element other than titanium, the proportion of the oxide constituting element other than titanium is preferably at most 30 atomic %, more preferably at most 20 atomic %, further preferably at most 10 atomic % in the total amount (100 atomic %) of titanium and the oxide constituting element (excluding oxygen) other than titanium with a view to making the visible light transmittance and the near infrared transmittance high. The antioxidant barrier layer 34 preferably consists solely of an oxide of titanium, particularly preferably consists solely of TiOₓ (1 <x<2) which is an oxide deficient in oxygen relative to the stoichiometric composition, with a view to making the visible light transmittance and the near infrared transmittance high.

The antioxidant barrier layer 34 is partially or entirely oxidized at the time of forming the second transparent oxide layer 35. Accordingly, after formation of the second transparent oxide layer 35, the antioxidant barrier layer 34 does not necessarily consist of an oxide deficient in oxygen relative to the stoichiometric composition, and for example, it may comprise an oxidized layer having a stoichiometric composition formed by oxidation and a non-oxidized layer remaining without being oxidized, or may consist solely of an oxide layer having a stoichiometric composition formed by oxidation.

The thickness of the antioxidant barrier layer 34 is preferably at least 3 nm. When the thickness of the antioxidant barrier layer 34 is at least 3 nm, oxidation of the low emissivity metal layer 33 can effectively be suppressed. The thickness of the antioxidant·barrier layer 34 is not particularly limited so long as it is at least 3 nm, but a thickness of 10 nm is sufficient to suppress oxidation of the low emissivity metal layer 3, and when the thickness is at most 10 nm, the film forming time can be shortened, thus improving the productivity.

The second transparent oxide layer 35 is not particularly limited so long as it has a refractive index of at least 1.9, and for example, it is preferably one containing an oxide of zinc. By containing an oxide of zinc, the material cost can be reduced, and in addition, the production cost can be reduced by an improvement in the film forming rate. The second transparent oxide layer 35 preferably contains an oxide of zinc as the main component. "Containing an oxide of zinc as the main component" means that zinc is contained in a proportion of at least 50 mass% in the total amount (100 mass%) of zinc and an oxide constituting element (excluding oxygen) other than zinc.

The second transparent oxide layer 35 may contain an oxide constituting element other than zinc. The oxide constituting element other than zinc may, for example, be tin, aluminum, chromium, titanium, silicon, boron, magnesium or gallium, and one or more of them may be contained. By containing the oxide constituting element other than zinc, favorable adhesion to the antioxidant barrier layer 34 is achieved and in addition, the visible light transmittance and the near infrared transmittance can be made high.

Zinc, tin, aluminum, chromium, titanium, silicon, boron, magnesium and gallium are contained in the second transparent oxide layer 35, for example, as tin oxide (SnO₂), aluminum oxide (Al₂O₃), chromium oxide (Cr₂O₃), titanium oxide (TiO₂), silicon oxide (SiO₂), boron oxide (B₂O₃), magnesium oxide (MgO) and gallium oxide (Ga₂O₃), respectively, or a composite oxide thereof. Among the oxide constituting elements, aluminum or tin is more preferred, whereby the second transparent oxide layer 35 will be well compatible with the antioxidant barrier layer 34. Further, aluminum is particularly preferred since it is an inexpensive material and it can make the film forming rate high, and tin is also preferred since it is a relatively inexpensive material.

In a case where the second transparent oxide layer 35 contains an oxide constituting element other than zinc, the proportion of the oxide constituting element other than zinc is preferably from 1 to 50 mass% in the total amount (100 mass%) of zinc and the oxide constituting element (excluding oxygen) other than zinc. For example, in a case where it contains aluminum as the oxide constituting element other than zinc, the proportion of aluminum is more preferably from 1 to 10 mass%, particularly preferably from 1 to 5 mass% in the total amount (100 mass%) of zinc and aluminum.

The second transparent oxide layer 35 may be one containing an oxide of tin as the main component, other than one containing an oxide of zinc (zinc oxide (ZnO)) as the main component. With respect to one containing an oxide of tin (tin oxide (SnO₂)), the material cost can be reduced, and the production cost can be reduced by an improvement in the film forming rate. Further, the internal stress can be reduced, favorable compatibility with the antioxidant barrier layer 34 is achieved, and the durability of the thin film laminate portion 3 can be improved. The second transparent oxide layer 35 containing an oxide of tin as the main component is more preferably one containing tin in a proportion of at least 50 mass% in the total amount (100 mass%) of tin and an oxide constituting element (excluding oxygen) other than tin.

The second transparent oxide layer 35 may be one comprising titanium oxide (TiO₂), niobium oxide (Nb₂O₅), tantalum oxide (Ta₂O₅), tungsten oxide (WO₃), molybdenum oxide (MoO₃) or a composite oxide thereof, other than one containing an oxide of zinc or an oxide of tin. With the second transparent oxide layer 35 comprising such an oxide, the same optical properties can be obtained as those of one containing an oxide of zinc or an oxide of tin, although the material cost and the production cost are slightly increased as compared with one containing an oxide of zinc or an oxide of tin.

The thickness of the second transparent oxide layer 35 is not necessarily limited and is preferably from 30 to 60 nm. By the thickness being at least 30 nm, the visible light transmittance and the near infrared transmittance can be made high, and it is possible to prevent the surface from being reddish, thus leading to favorable outer appearance. A thickness of the second transparent oxide layer 35 of 60 nm is sufficient to make the visible light transmittance and the near infrared transmittance high, and by a thickness of at most 60 nm, the film forming time can be shortened, thus leading to favorable productivity. The thickness of the second transparent oxide layer 35 is more preferably from 40 to 50 nm from the viewpoint of the visible light transmittance and the near infrared transmittance, the outer appearance, the productivity, etc.

With respect to the first transparent oxide layer (first titanium oxide-containing layer) 31 and the antioxidant barrier layer (second titanium oxide-containing layer) 34 i.e. titanium oxide-containing layers each containing an oxide of titanium, formed to sandwich the low emissivity metal layer 33, it is preferred that the first transparent oxide layer 31 to be on the transparent substrate 2 side relative to the low emissivity metal layer 33 is formed by using a target having a low oxidation degree as compared with the antioxidant barrier layer 34 to be on the opposite side. In such a constitution, the first transparent oxide layer 31 can have a high compressive stress, and the surface resistivity of the low emissivity coating stack 1 can be lowered without increasing the thickness of the low emissivity metal layer 33. Thus, the emissivity for heat rays can be lowered and in addition, the visible light transmittance and the near infrared transmittance can be made high, and a high solar heat gain coefficient when formed into double glazing glass can be obtained.

For example, the first transparent oxide layer (first titanium oxide-containing layer) 31 is preferably formed in the form of TiO₂ by carrying out reactive sputtering in a sputtering gas with a sufficiently high oxidizing gas concentration using a metal target containing titanium as a sputtering target. Further, the antioxidant barrier layer (second titanium oxide-containing layer) 34 is preferably formed in the form of TiOₓ (1<x<2) by carrying out sputtering in a sputtering gas with a low oxidizing gas concentration as compared with the above reactive sputtering, using, as a sputtering target, a reducing oxide target containing an oxide of titanium and comprising an oxide deficient in oxygen relative to the stoichiometric composition.

The above metal target is preferably one containing titanium as the main component i.e. containing titanium in a proportion of at least 50 atomic % in the total amount (100 atomic %) of titanium and an element other than titanium, more preferably one consisting solely of titanium. Further, the reducing oxide target is preferably one containing an oxide of titanium as the main component i.e. one containing titanium in a proportion of at least 50 atomic % in the total amount (100 atomic %) of titanium and an oxide constituting element (excluding oxygen) other than titanium, more preferably one consisting solely of TiOₓ (1<x<2), particularly preferably one consisting solely of TiOₓ (1.5<x<2.0).

Fig. 2 is a cross sectional view schematically illustrating one example of a low emissivity coating stack 1 according to a second embodiment.

The low emissivity coating stack 1 is not limited to one having an antioxidant barrier layer 34 and a second transparent oxide layer 35 as in the case of the low emissivity coating stack 1 according to a first embodiment as shown in Fig. 1, and may, for example, be one containing only a second transparent oxide layer 35, not containing an antioxidant barrier layer 34, as shown in Fig. 2. In such a case, the second transparent oxide layer 35 corresponds to the second titanium oxide-containing layer in the present invention. This second transparent oxide layer 35 may have the same composition as the antioxidant barrier layer 34 in the low emissivity coating stack 1 according to a first embodiment.

The thickness of the second transparent oxide layer 35 according to a second embodiment is not necessarily limited and is preferably from 30 to 60 nm. By the thickness being at least 30 nm, the visible light transmittance and the near infrared transmittance can be made high, and it is possible to prevent the surface from being reddish, thus leading to favorable outer appearance. A thickness of the second transparent oxide layer 35 of 60 nm is sufficient to make the visible light transmittance and the near infrared transmittance high, and by the thickness being at most 60 nm, the film forming time can be shortened, thus leading to favorable productivity. The thickness of the second transparent oxide layer 35 is more preferably from 40 to 50 nm from the viewpoint of the visible light transmittance and the near infrared transmittance, the outer appearance, the productivity, etc.

With respect to the first transparent oxide layer (first titanium oxide-containing layer) 31 and the second transparent oxide layer (second titanium oxide-containing layer) 35 according to a second embodiment i.e. titanium oxide-containing layers each containing an oxide of titanium formed to sandwich the low emissivity metal layer 33, it is preferred that the first transparent oxide layer 31 to be the transparent substrate 2 side relative to the low emissivity metal layer 33 is formed in the form of TiO₂ using a target having a low oxidation degree as compared with the second transparent oxide layer 35 to be on the opposite side. By such a constitution, the first transparent oxide layer 31 can have a high compressive stress, and the surface resistivity of the low emissivity coating stack 1 can be lowered without increasing the thickness of the low emissivity metal layer 33. Thus, the emissivity for heat rays can be lowered and in addition, the visible light transmittance and the near infrared transmittance can be made high, and a high solar heat gain coefficient when formed into double glazing glass can be obtained.

Here, in a case where only the second transparent oxide layer 35 is formed without forming the antioxidant barrier layer 34, as in the case of the low emissivity coating stack 1 according to a second embodiment, it is necessary to form the second transparent oxide layer 35 thickly by using a reducing oxide target containing an oxide of titanium, and the material cost and the production cost tend to increase as compared with the low emissivity coating stack 1 according to a first embodiment. Accordingly, from the viewpoint of the material cost and the production cost, it is preferred to form the antioxidant barrier layer 34 and the second transparent oxide layer 35 as in the case of the low emissivity coating stack 1 according to a first embodiment.

The low emissivity coating stack 1 of the present invention is characterized by having a surface resistivity of at most 3.3 Ω/□ and having a solar heat gain coefficient of at least 0.60 when formed into double glazing glass. The low emissivity coating stack 1 of the present invention can have a surface resistivity of at most 3.3 Ω/□ and a solar heat gain coefficient of at least 0.60 when formed into double glazing glass, by forming the first transparent oxide layer 31 to be on the transparent substrate 2 side relative to the low emissivity metal layer 33 using a target having a low oxidation degree as compared with the antioxidant barrier layer 34 (first embodiment) or the second transparent oxide layer 35 (second embodiment) to be on the opposite side.

The surface resistivity is not particularly limited so long as it is at most 3.3 Ω/□, and is usually preferably from 2.0 to 3.2 Ω/□. To measure the surface resistivity, a known surface resistance measuring apparatus may be used, and for example, portable surface resistance measuring apparatus "STRATOMETER" manufactured by NAGY may be preferably used. Measurement was carried out by using a 100 mm square laminate in a state where an element portion on the measurement apparatus side was applied to a center portion of the laminate without the measuring apparatus being inclined.

The solar heat gain coefficient when formed into double glazing glass is not particularly limited so long as it is at least 0.60, and is usually preferably from 0.60 to 0.65. Double glazing glass to measure the solar heat gain coefficient is not particularly limited, and may, for example, be one having float plate glass having a thickness of 3 mm disposed with a space of 15 mm on the low emissivity coating stack 1 and having argon gas sealed in the space between them. The low emissivity coating stack 1 of the present invention has a solar heat gain coefficient of at least 0.60 when formed into such double glazing glass. The solar heat gain coefficient is obtained in accordance with JIS R3106-1998.

The low emissivity coating stack 1 of the present invention is preferably such that the total film stress is a compressive stress of at least 23 Pa·m. By a compressive stress of at least 23 Pa·m, the low emissivity coating stack 1 can have a surface resistivity of at most 3.3 Ω/□ and a solar heat gain coefficient of at least 0.60 when formed into double glazing glass. According to the low emissivity coating stack 1 of the present invention, the total film stress of a compressive stress of at least 23 Pa·m can be obtained, by forming the first transparent oxide layer 31 to be on the transparent substrate 2 side relative to the low emissivity metal layer 33 using a target having a low oxidation degree as compared with the antioxidant barrier layer 34 (first embodiment) or the second transparent oxide layer 35 (second embodiment) to be on the opposite side, in addition to the above constitution.

The total film stress of the low emissivity coating stack 1 is not particularly limited so long as the compressive stress is at least 23 Pa·m, and usually the compressive stress is preferably from 24 to 30 Pa·m. The total film stress can be measured by laminating a thin film laminate portion having the same constitution as the thin film laminate portion 3 of the low emissivity coating stack 1 on a silicon wafer, using, for example, FLX-2320 Thin Film Stress Measurement System manufactured by KLA-Tencor Corporation.

The low emissivity coating stack 1 of the present invention can be produced by forming the respective layers constituting the thin film laminate portion 3 by a sputtering method on the transparent substrate 2. The low emissivity coating stack 1 of the present invention is preferably produced, as described above, by forming the first transparent oxide layer 31 to be on the transparent substrate 2 side relative to the low emissivity metal layer 33 using a target having a low oxidation degree as compared with the antioxidant barrier layer 34 (first embodiment) or the second transparent oxide layer 35 (second·embodiment) to be on the opposite side.

For example, the first transparent oxide layer 31 is preferably formed in the form of TiO₂ by carrying out reactive sputtering in a sputtering gas with a sufficiently high oxidizing gas concentration using a metal target containing titanium as a sputtering target. Further, the antioxidant barrier layer 34 (first embodiment) or the second transparent oxide layer 35 (second embodiment) is preferably formed in the form of TiOₓ by carrying out sputtering in a sputtering gas with a low oxidizing gas concentration as compared with the above reactive sputtering by using, as a sputtering target, a reducing oxide target containing an oxide of titanium, and comprising an oxide deficient in oxygen relative to the stoichiometric composition.

The metal target is preferably one containing titanium as the main component i.e. containing titanium in a proportion of at least 50 atomic % in the total amount (100 atomic %) of titanium and an element other than titanium. The metal target may contain additional elements other than titanium. The additional elements other than titanium may, for example, be niobium, tantalum, zirconium, silicon, tungsten and molybdenum, and one or more of them may be contained. In a case where the metal target contains the additional elements other than titanium, their proportion is preferably at most 30 atomic %, more preferably at most 20 atomic %, further preferably at most 10 atomic % in the total amount (100 atomic %) of titanium and the additional elements other than titanium. The metal target is particularly preferably one consisting solely of titanium, with a view to making the visible light transmittance and the near infrared transmittance high.

The reducing oxide target is preferably one containing an oxide of titanium as the main component i.e. one containing titanium in a proportion of at least 50 atomic % in the total amount (100 atomic %) of titanium and an oxide constituting element (excluding oxygen) other than titanium. The reducing oxide target may contain an oxide constituting element other than titanium. The oxide constituting element other than titanium may, for example, be niobium, tantalum, zirconium, silicon, tungsten or molybdenum, and one or more of them may be contained.

Titanium, niobium, tantalum, zirconium, silicon, tungsten and molybdenum are contained in the reducing oxide target, for example, as TiOₓ (1 <x<2), Nb₂Oₓ (4<x<5), Ta₂Oₓ (4<x<5), ZrOₓ (1<x<2), SiOₓ(1<x<2), WOₓ (2<x<3) and MoOₓ (2<x<3), respectively, or a composite oxide thereof.

In a case where the reducing oxide target contains the oxide constituting element other than titanium, the proportion of the oxide constituting element other than titanium is preferably at most 30 atomic %, more preferably at most 20 atomic %, further preferably at most 10 atomic % in the total amount (100 atomic %) of titanium and the oxide constituting element (excluding oxygen) other than titanium. The reducing oxide target is particularly preferably one consisting solely of TiOₓ (1 <x<2) with a view to making the visible light transmittance and the near infrared transmittance high.

Such a reducing oxide target may be prepared, for example, by a high pressure pressing method, a sintering method or a flame spraying method as disclosed in WO97/08359 using a mixture of an oxide powder and an oxide constituting metal powder.

The first transparent oxide layer 31 is preferably formed in the form of TiO₂ by using a metal target and by using a sputtering gas containing from 30 to 100 vol% of an oxidizing gas and containing an inert gas as the rest. By such a film forming method, the first transparent oxide layer 31 can have high visible light transmittance and near infrared transmittance. As the oxidizing gas, oxygen gas is commonly used.

The antioxidant barrier layer 34 (first embodiment) and the second transparent oxide layer 35 (second embodiment) are preferably formed in the form of TiOₓ by carrying out sputtering by using a reducing oxide target and by using a sputtering gas containing at most 10 vol% of an oxidizing gas and containing an inert gas as the rest. By the oxidizing gas concentration within the above range, oxidation of the low emissivity metal layer 33 can effectively be suppressed. As the oxidizing gas, an oxygen gas is commonly used, but nitrogen monooxide, nitrogen dioxide, carbon monooxide, carbon dioxide, ozone or the like may also be used.

The method for forming the base oxide layer 32 (first and second embodiments) and the second transparent oxide layer 35 (first embodiment) is not particularly limited. The base oxide layer 32 and the second transparent oxide layer 35 can be formed, for example, by carrying out reactive sputtering in a sputtering gas with a sufficiently high oxidizing gas concentration using a metal target as a sputtering target. As the metal target, for example, a metal target containing zinc is suitably used.

The metal target containing zinc may contain an oxide constituting element other than zinc. The oxide constituting element other than zinc may, for example, be tin, aluminum, chromium, titanium, silicon, boron, magnesium or gallium, and one or more of them may be contained. In a case where an oxide constituting element other than zinc is contained, the proportion of the oxide constituting element other than zinc is preferably from 1 to 50 mass% in the total amount (100 mass%) of zinc and the oxide constituting element other than zinc.

The method for forming the low emissivity metal layer 33 is also not particularly limited. The low emissivity metal layer 33 can be formed, for example, by carrying out sputtering in an inert gas using a target containing at least 90 mass% of silver as a sputtering target. The metal target may contain, in addition to silver, one or more of additional elements selected from palladium, gold and platinum. In a case where the metal target contains such additional elements, their total content is preferably from 0.1 to 10 mass%.

The low emissivity coating stack 1 of the present invention is suitably used as double glazing glass.

Fig. 3 shows one example of double glazing glass 10. Double glazing glass 10 comprises a low emissivity coating stack 1 and a transparent counter substrate 11 such as a glass substrate disposed to face the low emissivity coating stack 1, and has a spacer 13 disposed to form an interlayer 12 between the low emissivity coating stack 1 and the transparent counter substrate 11. Here, the low emissivity coating stack 1 is disposed on the interior side relative to the transparent counter substrate 11, and is disposed so that the thin film laminate portion 3 as shown in Fig. 1 or 2 is located on the interlayer 12 side and faces the transparent counter substrate 11.

In the interlayer 12, for example, an argon gas is sealed. The space between the low emissivity coating stack 1 and the spacer 13 and the space between the transparent counter substrate 11 and the spacer 13, are sealed with a primary sealing material 14. Further, the peripheral portion of the space between the laminate 1 and the transparent counter substrate 11 is sealed with a secondary sealing material 15. A space 131 is formed in the interior of the spacer 13, and a hole 132 to connect the space 131 to the interlayer 12 is formed, and the space 131 is filled with a desiccating agent 16 to suppress moisture condensation in the interlayer 12.

The double glazing glass 10 can have a solar heat gain coefficient of at least 0.60 by using the low emissivity coating stack 1 of the present invention. The solar heat gain coefficient is not particularly limited so long as it is at least 0.60, and is preferably at least 0.61. The solar heat gain coefficient is obtained in accordance with JIS R3106: 1998.

Further, the double glazing glass 10 can have a thermal transmittance of at most 1.15 W/m²·K by using the low emissivity coating stack 1 of the present invention. The thermal transmittance can be obtained in accordance with JIS R3107: 1998.

Further, the double glazing glass 10 can have a visible light transmittance (Tv) of at least 70% by using the low emissivity coating stack 1 of the present invention. The visible light transmittance (Tv) can be obtained in accordance with JIS R3106: 1998.

Now, the mechanism how the predetermined surface resistivity, etc. are obtained, will be specifically described.

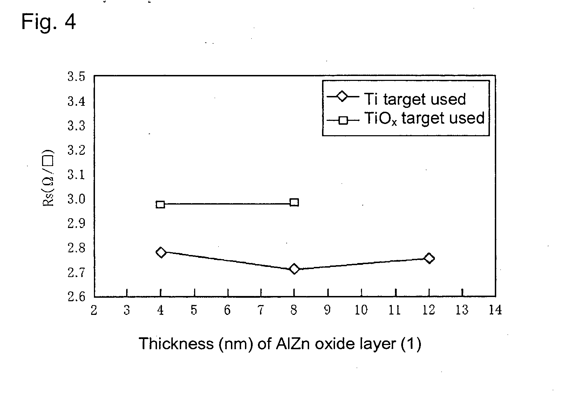

Fig. 4 shows the surface resistivities (Rs) of laminates produced by forming, on a glass substrate (100 mm × 100 mm × 3 mm (thickness)) as a transparent substrate, a transparent oxide layer (TiO₂ layer, thickness: 20 nm) comprising an oxide of titanium (TiO₂), a transparent oxide layer (AlZn oxide layer (1)) comprising an oxide of zinc and aluminum, a low emissivity metal layer (Ag layer, thickness: 14 nm) comprising silver, an antioxidant barrier layer (AlZn alloy layer, thickness: 1.15 nm) comprising zinc and aluminum, and a transparent oxide layer (AlZn oxide layer (2), thickness: 48 nm) comprising an oxide of zinc and aluminum, in this order on the glass substrate, wherein the TiO₂ layer is formed by using a titanium target (Ti target) and wherein the TiO₂ layer is formed by using a target comprising an oxide of titanium (TiOₓ target (x=1.9)). The thickness of the AlZn oxide layer (1) was changed to determine the optimum film thickness with which a minimum surface resistivity is obtained, for comparison. Methods for forming the respective layers will be described below.

### <TiO₂ layer (Ti target used)>

As a discharge gas, argon and oxygen were introduced into a vacuum chamber at a flow ratio of 600 sccm : 400 sccm, and reactive AC magnetron sputtering was carried out using a Ti target to form a TiO₂ layer. The sputtering target was in the form of a tube having a length of 1,778 mm, and 40 kW was applied as a sputtering power. On that occasion, the pressure in the vacuum chamber was 4×10⁻³ mbar.

### <TiO₂ layer (TiOₓ target used)>

As a discharge gas, argon and oxygen were introduced into a vacuum chamber at a flow ratio of 600 sccm : 40 sccm, and AC magnetron sputtering was carried out using a TiOₓ target (x=1.9) to form a TiO₂ layer. The sputtering target was in the form of a tube having a length of 1,778 mm, and 48 kW was applied as a sputtering power. On that occasion, the pressure in the vacuum chamber was 3.9×10⁻³ mbar.

### <AlZn oxide layer (1), (2)>

As a discharge gas, argon and oxygen were introduced into a vacuum chamber at a flow ratio of 1,000 sccm : 900 sccm, and reactive AC magnetron sputtering was carried out using a target comprising a zinc alloy containing 2 mass% of aluminum (AlZn alloy target) to form an AlZn oxide layer. The sputtering target was in the form of a tube having a length of 1,778 mm, and 30 kW was applied as a sputtering power. On that occasion, the pressure in the vacuum chamber was 7.0×10⁻³ mbar.

### <Ag layer>

As a discharge gas, 1,000 sccm of argon was introduced into a vacuum chamber, and AC magnetron sputtering was carried out using a silver target (Ag target) to form a Ag layer. The area of the sputtering target was 100×1,700 mm², and 3 kW was applied as a sputtering power. On that occasion, the pressure in the vacuum chamber was 5.0×10⁻³ mbar.

### <AlZn alloy layer>

As a discharge gas, 1,000 sccm of argon was introduced into a vacuum chamber, and AC magnetron sputtering was carried out using a target comprising a zinc alloy containing 2 mass% of aluminum (AlZn alloy target) to form an AlZn alloy layer. The sputtering target was in the form of a tube having a length of 1,778 mm, and 1 kW was applied as a sputtering power. On the occasion, the pressure in the vacuum chamber was 4.5×10⁻³ mbar.

As evident from Fig. 4, the surface resistivity of the low emissivity coating stack can be remarkably reduced when the TiO₂ layer is formed by reactive sputtering using a Ti target, as compared with a case where it is formed by using a TiOₓ target.

Table 1 represents the thickness of the Ag layer (low emissivity metal layer) required to achieve a surface resistivity of the low emissivity coating stack of 3 Ω/□, with respect to low emissivity coating stacks having substantially the same constitution as the low emissivity coating stack used to determine the relation between the target material and the surface resistivity (Rs) of the low emissivity coating stack shown in Fig. 4 (hereinafter the low emissivity coating stack used to determine the relation of Fig. 4 will be referred to as "low emissivity coating stack for Fig. 4"), wherein the TiO₂ layer was formed by reactive sputtering using a Ti target and wherein the TiO₂ layer is formed by using a TiOₓ target.

The low emissivity coating stack had the same constitution as the low emissivity coating stack for Fig. 4 except that the AlZn alloy layer as the antioxidant barrier layer was changed to a TiOₓ layer (x=1.9). That is, the low emissivity coating stack comprises a glass substrate (100 mm × 100 mm × 3 mm (thickness)) as a transparent substrate, and a transparent oxide layer (TiO₂ layer, thickness: 20 nm) comprising an oxide of titanium (TiO₂), a transparent oxide layer (AlZn oxide layer (1), 8 nm) comprising an oxide of zinc and aluminum, a low emissivity metal layer (Ag layer) comprising silver, an antioxidant barrier layer (thickness: 5 nm) comprising TiOₓ (x=1.9) and a transparent oxide layer (AlZn oxide layer (2), thickness: 48 nm) comprising an oxide of zinc and aluminum formed in this order on the glass substrate.

The respective layers were formed under the same conditions for the low emissivity coating stack for Fig. 4.

**TABLE 1**

| TiO₂ layer | Thickness of Ag layer (low emissivity metal layer) required to achieve surface resistivity of 3 Ω/□ |
|---|---|
| Ti target used | 13.5 nm |
| TiOₓ target used | 16.0 nm |

As shown in Table 1, it is found that the thickness of the Ag layer (low emissivity metal layer) required to obtain a predetermined surface resistivity can be reduced by forming the TiO₂ layer as the titanium oxide-containing layer to be on the transparent substrate side by reactive sputtering using a Ti target. Thus, the visible light transmittance and the near infrared transmittance can be made high, and a high solar heat gain coefficient when formed into double glazing glass can be made high, while the emissivity for heat rays is made low.

### EXAMPLES

Now, the low emissivity coating stack of the present invention will be described in further detail with reference to Examples.

As the low emissivity coating stack, low emissivity coating stack samples (1-1) to (3-5) having a constitution as shown in Table 2 (composition and film thickness when the respective layers were formed) were produced. That is, on a glass substrate (FL3 (float glass plate having a thickness of 3 mm, visible light transmittance: 90.4%)) of 100 mm × 100 mm × 3 mm (thickness) as a transparent substrate, a tin film laminate portion was formed by a DC sputtering method. The low emissivity coating stack sample 2-1 corresponds to an Example of the present invention.

Each of the low emissivity coating stack samples (1-1) to (1-3) comprises a glass substrate, and a tin film laminate portion produced by forming a titanium oxide layer (TiO₂ layer, first transparent oxide layer), a layer of an oxide of zinc and aluminum (AlZn oxide layer, base oxide layer), a silver layer (Ag layer, low emissivity metal layer), a layer of an alloy of zinc and aluminum (AlZn alloy layer, antioxidant barrier layer) and a layer of an oxide of zinc and tin (SnZn oxide layer, second transparent oxide layer) in this order on the glass substrate.

Each of the low emissivity coating stack samples (2-1) to (3-5) comprises a tin film laminate portion having a titanium reducing oxide layer (TiOₓ layer (x=1.9)) formed instead of the AlZn alloy layer (antioxidant barrier layer) of each of the low emission laminate samples (1-1) to (1-3). For each of the low emissivity coating stack samples (2-1) to (2-3), a titanium target (Ti target) was used for forming the TiO₂ layer (first transparent oxide layer), and for each of the low emissivity coating stack samples (3-1) to (3-5), a titanium reducing oxide target (TiOₓ target (x=1.9)) was used for forming the TiO₂ layer (first transparent oxide layer).

In an in-line sputtering apparatus used for sputtering, in a film forming chamber, a titanium target (Ti target), a target (TiOₓ target) comprising a reducing oxide of titanium (TiOₓ (x=1.9)), a target (AlZn alloy target) comprising a zinc alloy containing 2 mass% of aluminum, a silver target (Ag target) and a target (SnZn alloy target) comprising a zinc alloy containing 50 mass% of tin were placed on a cathode. Further, a cleaned glass substrate was introduced in a load lock chamber, and the entire vacuum chamber was evacuated of air to a vacuum of 2.0×10⁻⁴ Pa, and the respective layers were formed as follows.

### <TiO₂ layer (Ti target used)> (First transparent oxide layer)

As a discharge gas, argon and oxygen were introduced into the vacuum chamber at a flow ratio of 30 sccm : 70 sccm, and reactive DC magnetron sputtering was carried out using the above Ti target. The sputtering target had an area of 70x200 mm², and 500 W was applied as a sputtering power. On that occasion, the pressure in the vacuum chamber was 0.4 Pa. The thickness of the TiO₂ layer was 20 nm.

### <TiO₂ layer (TiOₓ target used)> (First transparent oxide layer)

As a discharge gas, argon and oxygen were introduce into the vacuum chamber at a flow ratio of 98 sccm : 2 sccm, and DC magnetron sputtering was carried out using the above TiOₓ target (x=1.9). The sputtering target had an area of 70x200 mm², and 500 W was applied as a sputtering power. On that occasion, the pressure in the vacuum chamber was 0.4 Pa. The thickness of the TiO₂ layer was 20 nm.

### <AlZn oxide layer> (Base oxide layer)

As a discharge gas, argon and oxygen were introduced into the vacuum chamber at a flow ratio of 30 sccm : 70 sccm, and reactive DC magnetron sputtering was carried out using the above AlZn alloy target. The size of the sputtering target was 70x200 mm², and 500 W was applied as a sputtering power. On that occasion, the pressure in the vacuum chamber was 0.4 Pa. The thickness of the AlZn oxide layer was 8 nm.

### <Ag layer> (Low emissivity metal layer)

As a discharge gas, 50 sccm of argon was introduced into the vacuum chamber, and DC magnetron sputtering was carried out using the above Ag target. The size of the sputtering target was 70×200 mm², and 100 W was applied as a sputtering power. On that occasion, the pressure in the vacuum chamber was 0.4 Pa. The thickness of the Ag layer was changed as identified in Table 2.

### <AlZn alloy layer> (Antioxidant barrier layer)

As a discharge gas, 100 sccm of argon was introduced into the vacuum chamber, and DC magnetron sputtering was carried out using the above AlZn alloy target. The size of the sputtering target was 70x200 mm², and 15 W was applied as a sputtering power. On that occasion, the pressure in the vacuum chamber was 0.4 Pa. The thickness of the AlZn alloy layer was 0.7 nm.

### <TiOₓ layer> (Antioxidant barrier layer)

As a discharge gas, 100 sccm of argon was introduced into the vacuum chamber, and DC magnetron sputtering was carried out using the above TiOₓ target (x=1.9). The size of the sputtering target was 70×200 mm², and 50 W was applied as a sputtering power. On that occasion, the pressure in the vacuum chamber was 0.4 Pa. The thickness of the TiOₓ layer was 5 nm.

### <SnZn oxide layer> (First transparent oxide layer)

As a discharge, argon and oxygen were introduced into the vacuum chamber at a flow ratio of 30 sccm : 70 sccm, and reactive DC magnetron sputtering was carried out using the above SnZn alloy target. The size of the sputtering target was 70×200 mm², and 500 W was applied as a sputtering power. On that occasion, the pressure in the vacuum chamber was 0.4 Pa. The thickness of the SnZn oxide layer was 48 nm.

The surface resistivity (Rs) of each of the low emissivity coating stack samples (1-1) to (3-5) thus produced was measured. The surface resistivity (Rs) was measured by using a portable surface resistance measuring apparatus "STRATOMETER" manufactured by NAGY.

Further, the performance when each of the low emissivity coating stack samples (1-1) to (3-5) was formed into double glazing glass was obtained by calculation from results of measurement by a spectrophotometer and results of measurement of the emissivity regarding the samples. The double glazing glass comprised each low emissivity coating stack and a glass substrate (FL3 (float glass plate having a thickness of 3 mm, visible light transmittance: 90.4%)) having a thickness of 3 mm as a transparent counter substrate disposed to face the low emissivity coating stack, the thickness of the interlayer between the low emissivity coating stack and the transparent counter substrate was 15 mm, and an argon gas was filled in the interlayer. The measurement by a spectrophotometer was carried out by UV31 00 manufactured by SHIMADZU CORPORATION. The emissivity was obtained by a conversion formula between preliminarily obtained results of measurement by FT/IR-420 manufactured by JASCO Corporation and the surface resistivity.

With respect to double glazing glass using each of the low emissivity coating stack samples (1-1) to (3-5), the thermal transmittance (U), the solar heat gain coefficient (g) and the visible light transmittance (Tv) were obtained by calculation. The thermal transmittance was obtained in accordance with JIS R3107: 1998. The solar heat gain coefficient (g) and the visible light transmittance (Tv) were obtained in accordance with JIS R3106: 1998. The results are shown in Table 2.

**TABLE 2**

| Sample | Constitution of low emissivity coating stack (when the respective layers were formed) | Low emissivity coating stack | | Double glazing glass | | |
|---|---|---|---|---|---|---|
| | | Ag film thickness [nm] | Rs [Ω/□] | U [W/m²·K] | g | Tv. [%] |
| 1-1 | Glass substrate/TiO₂ (Ti target used, 20 nm)/AlZn oxide (8 nm) /Ag/AlZn alloy (0.7 nm)/SnZn oxide (48 nm) | 13.5 | 3.32 | 1.16 | 0.62 | 77.0 |
| 1-2 | | 12.5 | 3.71 | 1.16 | 0.64 | 78.4 |
| 1-3 | | 11.5 | 4.28 | 1.20 | 0.67 | 78.6 |
| 2-1 | Glass substrate/TiO₂ (Ti target used, 20 nm)/AlZn oxide (8 nm) /Ag/TiOₓ (5 nm)/SnZn oxide (48 nm) | 13.5 | 3.07 | 1.12 | 0.62 | 77.0 |
| 2-2 | | 12.5 | 3.48 | 1.16 | 0.64 | 77.7 |
| 2-3 | | 11.5 | 3.83 | 1.16 | 0.66 | 78.2 |
| 3-1 | Glass substrate/TiO₂ (TiOₓ target used, 20 nm)/AlZn oxide (8 nm) /Ag/TiOₓ (0.7 nm)/SnZn oxide (48 nm) | 15.5 | 3.15 | 1.12 | 0.58 | 73.7 |
| 3-2 | | 14.5 | 3.42 | 1.16 | 0.60 | 74.2 |
| 3-3 | | 13.5 | 3.63 | 1.16 | 0.62 | 75.1 |
| 3-4 | | 12.5 | 4.01 | 1.16 | 0.64 | 73.5 |
| 3-5 | | 11.5 | 4.61 | 1.20 | 0.66 | 75.2 |

As evident from Table 2, according to the low emissivity coating stack sample (2-1) having the TiO₂ layer formed by using a Ti target as the first transparent oxide layer on the glass substrate and having the TiOₓ layer formed by using a TiOₓ target as the antioxidant barrier layer, a surface resistivity (Rs) of at most 3.3 Ω/□, and a solar heat gain coefficient (g) of at least 0.60 when formed into double glazing glass are obtained. Further, according to the low emissivity coating stack sample (2-1), a thermal transmittance (U) of at most 1.15 W/m²·K and a visible light transmittance (Tv) of at least 70 [%] when formed into double glazing glass are obtained.

Then, on a silicon wafer, the respective layers were formed as identified in Table 3 to produce each of low emissivity coating stack samples (4-1) to (4-4) for film stress measurement, and the surface resistivity and the total film stress were measured. Here, the low emissivity coating stack sample (4-3) for film stress measurement corresponds to an Example of the present invention. The respective layers were formed in the same manner as in the case of the low emissivity coating stack samples (1-1) to (3-5). The film stress was measured by using FLX-2320 Thin Film Stress Measurement System manufactured by KLA-Tencor Corporation. The results are shown in Table 3. With respect to the stress value, a positive value represents a tensile stress, and a negative value represents a compressive stress.

**TABLE 3**

| Sample | Film constitution | Total film thickness (nm) | Ag layer thickness (nm) | Rs (Ω/□) | Total stress (Pa·m) |
|---|---|---|---|---|---|
| 4-1 | Si/AlZn oxide (14 nm)/Ag (13.5 nm) /AlZn alloy (0.7 nm)/SnZn oxide (48 nm) | 82.5 | 13.5 | 4.06 | -20.8 |
| 4-2 | Si/TiO₂ (Ti target used, 20 nm)/AlZn oxide (8 nm) | 96.5 | 13.5 | 3.64 | -22.6 |
| 4-3 | Si/TiO₂ (Ti target used, 20 nm)/AlZn oxide (8 nm) /Ag (13.5 nm)/TiOₓ (5 nm)/SnZn oxide (48 nm) | 139.5 | 13.5 | 3.04 | -24.5 |
| 4-4 | Si/TiO₂ (TiOₓ target used, 20 nm)/AlZn oxide (8 nm) /Ag (13.5 nm)/TiOₓ (5 nm)/SnZn oxide (48 nm) | 139.5 | 13.5 | 4.12 | -16.6 |

As evident from Table 3, according to the low emissivity coating stack sample (4-3) for film stress measurement having the TiO₂ layer formed by using a Ti target as the first transparent oxide layer on the silicon wafer and having the TiOₓ layer formed by using a TiOₓ target as the antioxidant barrier layer, the compressive stress can be made large, and the surface resistivity can be made low as compared with the other samples having the same thickness of the Ag layer (low emissivity metal layer).

### INDUSTRIAL APPLICABILITY

According to the present invention, it is possible to provide a low emissivity coating stack having a sufficiently low emissivity for heat rays, having sufficiently high visible light transmittance and near infrared transmittance and having excellent properties as compared with a conventional product, and such a low emissivity coating stack is particularly useful for double glazing glass.

The entire disclosure of Japanese Patent Application No. 2011-119910 filed on May 30, 2011 including specification, claims, drawings and summary is incorporated herein by reference in its entirety.

### REFERENCE SYMBOLS

1: Low emissivity coating stack, 2: transparent substrate, 3: thin film laminate portion, 10: double glazing glass, 11: transparent counter substrate, 31: first transparent oxide layer (first titanium oxide-containing layer), 32: base oxide layer, 33: low emissivity metal layer, 34: antioxidant barrier layer (second titanium oxide-containing layer), 35: second transparent oxide layer (second titanium oxide-containing layer)

## Claims

1. A low emissivity coating stack having a surface resistivity of at most 3.3 Ω/□ and having a solar heat gain coefficient of at least 0.60 when formed into double glazing glass.

2. The low emissivity coating stack according to Claim 1, which comprises a transparent substrate, and a thin film laminate portion having at least a first titanium oxide-containing layer containing an oxide of titanium, a low emissivity metal layer containing silver as the main component and a second titanium oxide-containing layer containing an oxide of titanium formed in this order on the transparent substrate.

3. The low emissivity coating stack according to Claim 2, wherein each of the first titanium oxide-containing layer and the second titanium oxide-containing layer is formed by a sputtering method using a target material, and the first titanium oxide-containing layer is a layer formed by using a target material having an oxidation degree lower than the oxidation degree of a target material used for forming the second titanium oxide-containing layer.

4. The low emissivity coating stack according to Claim 2 or 3, wherein the first titanium oxide-containing layer is formed by using a metal target containing titanium, and the second titanium oxide-containing layer is formed by using a reducing oxide target containing an oxide of titanium.

5. The low emissivity coating stack according to any one of Claims 2 to 4, wherein the first titanium oxide-containing layer contains TiO₂ as the main component, the second titanium-oxide containing layer contains TiOₓ as the main component, and x is within a range of 1 <x<2.

6. The low emissivity coating stack according to any one of Claims 2 to 5, which has a base oxide layer formed on the first titanium oxide-containing layer, and the low emissivity metal layer containing silver as the main component formed on the base oxide layer.

7. The low emissivity coating stack according to any one of Claims 2 to 6, wherein the total film stress of the thin film laminate portion is a compressive stress of at least 23 Pa·m.

8. The low emissivity coating stack according to any one of Claims 2 to 7, wherein the visible light transmittance is at least 70% when formed into double glazing glass.

9. Double glazing glass comprising a low emissivity coating stack and a transparent counter substrate disposed to face the low emissivity coating stack, wherein the low emissivity coating stack is the low emissivity coating stack as defined in any one of Claims 1 to 8.
